# EUROPEAN PATENT SPECIFICATION

(11) **EP 0 570 618 B1**
(45) Date of publication and mention of the grant of the patent: **06.11.1996**
(21) Application number: 92112053.1
(22) Date of filing: 15.07.1992
(51) Int. Cl.: C23C 14/02, C23C 14/22, C23C 14/56

(54) **Film forming method and apparatus**
Verfahren und Vorrichtung zum Erzeugen von Dünnschichten
Méthode et appareil pour la formation d'une couche mince

(30) Priority: 21.05.1992 JP 128567/92; 21.05.1992 JP 128568/92
(43) Date of publication of application: 24.11.1993
(73) Proprietor: NISSIN ELECTRIC COMPANY, LIMITED, Ukyo-ku Kyoto-shi Kyoto (JP)
(72) Inventor: Ebe, Akinori, c/o Nissin Elec. Co., Ltd., Kyoto-shi, Kyoto (JP); Nishiyama, Satoshi, c/o Nissin Elec. Co., Ltd., Kyoto-shi, Kyoto (JP); Ogata, Kiyoshi, c/o Nissin Elec. Co., Ltd., Kyoto-shi, Kyoto (JP); Suzuki, Yasuo, c/o Nissin Elec. Co., Ltd., Kyoto-shi, Kyoto (JP)
(74) Representative: Grünecker, Kinkeldey, Stockmair & Schwanhäusser Anwaltssozietät

(56) References cited:
- EP-A- 0 269 112
- PATENT ABSTRACTS OF JAPAN vol. 8, no. 114 (C-225)(1551) 26 May 1984 & JP-A-59 028 567
- PATENT ABSTRACTS OF JAPAN vol. 14, no. 397 (C-752)(4340) 28 August 1990 & JP-A-21 49 661
- PATENT ABSTRACTS OF JAPAN vol. 8, no. 92 (P-271)(1529) 27 April 1984 & JP-A-59 005 436
- PATENT ABSTRACTS OF JAPAN vol. 7, no. 151 (C-174)(1296) 2 July 1983 & JP-A-58 061 273

## Description

### BACKGROUND OF THE INVENTION

### Field of the Invention

The present invention relates to a film forming method for continuously forming a desired film on a surface of a substrate selected from various kinds of materials such as macromolecular materials, metals, glass, ceramics, etc., and an apparatus therefor.

### Description of the Related Art

In recent years, film forming using vacuum evaporation of a particular material onto the surface of a substrate has been widely adapted for forming a metal film as a printed wiring precursor onto a printed wiring substrate formed from a macromolecular material, forming of a corrosion-resisting film onto a surface of a substrate formed from stainless steel or the like, and forming of a semiconductor film onto a liquid crystal display glass substrate, for example. Such vacuum evaporation film forming has an advantage in that the film forming speed is relatively high compared with film forming using sputtering or the like.

Vacuum evaporation film forming, however, has a problem in that mutual adhesion at the interface between the substrate surface and the film formed thereon is so weak that the film may be separated from the substrate when the substrate is processed after the film is formed. For example, where an aluminum film for printed wiring is formed on a surface of a printed wiring substrate formed of a polyimide film, a problem arises in that the aluminum film may be separated by exposure of the film to high or low temperature after the film is formed. In the case where a corrosion-resisting aluminum film is formed on a stainless steel substrate, for example, the aluminum film may be broken or separated when the stainless steel substrate is processed by bending, pressing or the like after the film is formed.

A method has been heretofore proposed to solve the aforementioned problems and in which vacuum evaporation of a particular material onto a surface of a substrate and ion radiation are used in combination to form an adhesive mixture layer of constituent atoms of the substrate material and constituent atoms of an evaporated material on a portion of the substrate surface to form an evaporation film of the same material and of a predetermined thickness on the mixture layer with good adhesion. A similar method is for example described in EP-A-0269112.

In forming the mixing layer to improve the adhesion, all the thickness of the resulting film is not necessary. That is, a film with an arbitrary thickness is formed by vacuum evaporation after the mixing layer is formed by ion radiation adjacent to the interface between the substrate and the film.

In such a film forming process using a combination of vacuum evaporation and ion radiation, continuous movement of a strip-like or plate-like substrate has been proposed for the purpose of film forming efficiency as for example described in JP-A-028567. In the method described there, no independent operation of ion source and evaporation source is possible.

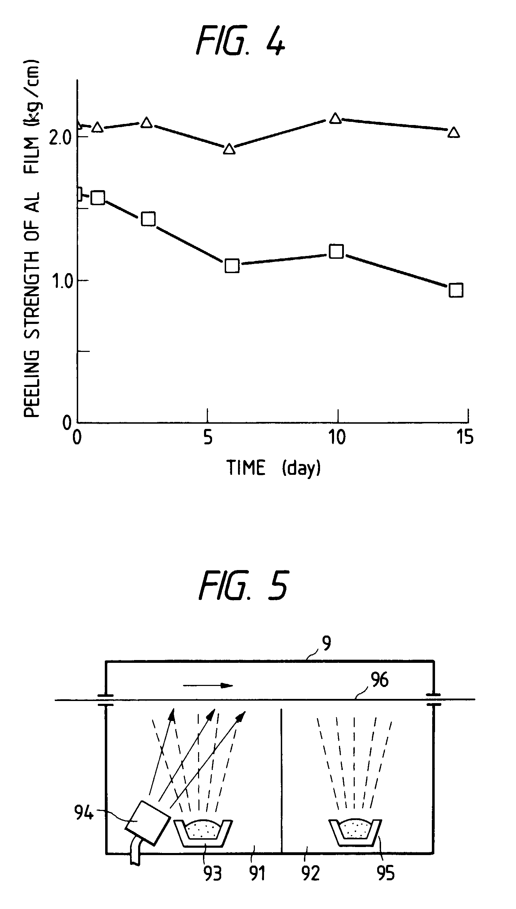

Fig. 5 shows another example of an apparatus for performing such continuous film forming, in which a vacuum vessel 9 capable of being kept in a predetermined vacuum by an exhaust device (not shown), is partitioned into two portions 91 and 92. One portion 91 is used for a material evaporation source 93 and an ion source 94 for forming a mixture layer, and the other portion 92 is used for a material evaporation source 95 for forming an evaporation film of predetermined thickness on the mixture layer. A substrate 96 is passed from the one portion 91 to the other portion 92 so that the mixture layer is formed at the portion 91 and then the evaporation film of predetermined thickness is formed at the portion 92.

The reason why the vacuum vessel 9 is partitioned into two film forming portions 91 and 92 is that if the film forming condition is suited to the moving speed of the substrate, it is necessary to reduce the speed of evaporation to satisfy the quantity of ion radiation in the mixture layer forming step. If the total film forming speed is increased, it is necessary to change the speed of evaporation between the mixture layer forming step and the evaporative film forming step.

Another method and apparatus have been proposed as described in Japanese Patent Unexamined Publication No. Sho-60-141869. In this proposed film forming method and apparatus, a first ion source, a first evaporation source, a second ion source and a second evaporation source (which may be combined with an ion plating means) are disposed in a vacuum vessel along the direction of substrate feed to carry out a pretreatment, such as cleaning, of the substrate surface using the first ion source, form an evaporation film for forming a mixture layer using the first evaporation source, form the mixture layer by ion radiation with the second ion source and form an evaporation film of a predetermined thickness on the mixture layer with the second evaporation source.

In the film forming method and apparatus described in each of Fig. 5 and Japanese Patent Unexamined Publication No. Sho-60-141869, not only at least one ion source and one evaporation source are necessary for forming the mixture layer, but at least one evaporation source is also necessary for forming the evaporation film. Thus, a problem is presented in that the number of evaporation sources is increased and film forming cost is increased.

In the method and apparatus described in Japanese Patent Unexamined Publication No. Sho-60-141869, the mixture layer is formed by performing ion injection with the second ion source after forming the evaporation film using the first evaporation source. Accordingly, ion energy due to the second ion source must be enlarged. Otherwise, great reduction of the substrate feeding speed may be considered, but production efficiency is compromised if the substrate feeding speed is reduced greatly.

### SUMMARY OF THE INVENTION

The present invention has been made in view of the above circumstances and has as an object to provide a film forming method and a film forming apparatus in which a film with good adhesion characteristics can be continuously formed on a substrate easily, at low cost and with good productivity as compared with the conventional method and apparatus.

Additional objects and advantages of the invention will be set forth in part in the description which follows and in part will be obvious from the description, or may be learned by practice of the invention. The objects and advantages of the invention may be realized and attained by means of the instrumentalities and combinations particularly pointed out in the appended claims.

To achieve the objects and in accordance with the purpose of the invention, as embodied and broadly described herein, the present invention provides a film forming method as described in independent claims 1 and 2.

The objects and purpose of the present invention are further achieved by a film forming apparatus comprising the features described in independent claims 5 and 6.

In the method and apparatus according to the present invention, various means for continuously moving the substrate may be used. For example, where the substrate is shaped as an endless belt, a moving means including a plurality of pulleys to advance the substrate may be used. In the case where the substrate is shaped as a doubled ended flexible belt, a moving means including a feed reel, a drum therefor, a take-up reel, and a drum to reciprocate the substrate may be used. For example, in the case where the substrate is shaped as a plate, various kinds of conveyers such as a roller conveyer to reciprocate the substrate may be considered.

In the method and apparatus according to the present invention, the direction of feeding of the substrate in the step of forming the evaporation film of the predetermined thickness on the mixture layer may be the same as the direction of feeding in the mixture layer forming step or may be opposite thereto. In the case where the substrate is shaped like a belt or a plate and is fed by reel devices or conveyer devices, the direction of feed to form the layer of evaporation material is opposite to the direction in the mixture layer forming step.

In the method and apparatus according to the present invention, the ion source may be suitably arranged so that a part of the ion radiation is simultaneously applied to an upstream substrate portion outside of the region reached by the evaporation material from the evaporation source.

The adhesion of the formed film to the substrate is greatly affected by the transport ratio. The preferred transport ratio varies according to the kind of the substrate, the material to be evaporated, the ion type used, the ion energy and the like, but it is generally preferable that the transport ratio is in a range of from about 10 to about 1000. If the transport ratio is smaller than 10, that is, the rate of ion radiation is larger, the substrate becomes so damaged that the adhesion of the film deteriorates. If the transport rate is larger than 1000, the resulting mixture layer is unsatisfactory.

In this case, the surface of the substrate is exposed to a part of the ion radiation to pretreat the substrate, such as by activating the substrate surface and cleaning to remove water, and then a mixture layer and a vacuum evaporation film are formed with a predetermined thickness.

### BRIEF DESCRIPTION OF THE DRAWINGS

The accompanying drawings, which are incorporated in and constitute a part of this specification illustrate embodiment(s) of the invention and, together with the description, serve to explain the objects, advantages and principles of the invention. In the drawings,
Fig. 1A is a schematic diagram of an embodiment of a film forming apparatus used for carrying out a method according to the present invention;
Fig. 1B is a schematic diagram of a modified embodiment of a film forming apparatus used for carrying out a method according to the present invention;
Fig. 2 is a graph showing the result of an aluminum film peeling strength test on a stainless steel plate;
Fig. 3 is a schematic diagram of another embodiment of the film forming apparatus used for carrying out a method according to the present invention;
Fig. 4 is a graph showing the result of an aluminum film peeling strength test on a polyimide film; and
Fig. 5 an explanatory view showing a conventional apparatus.

### DETAILED DESCRIPTION OF THE PREFERRED EMBODIMENTS

An embodiment of the film forming method of the present invention and an embodiment of the film forming apparatus therefor will be described hereunder with reference to the drawings.

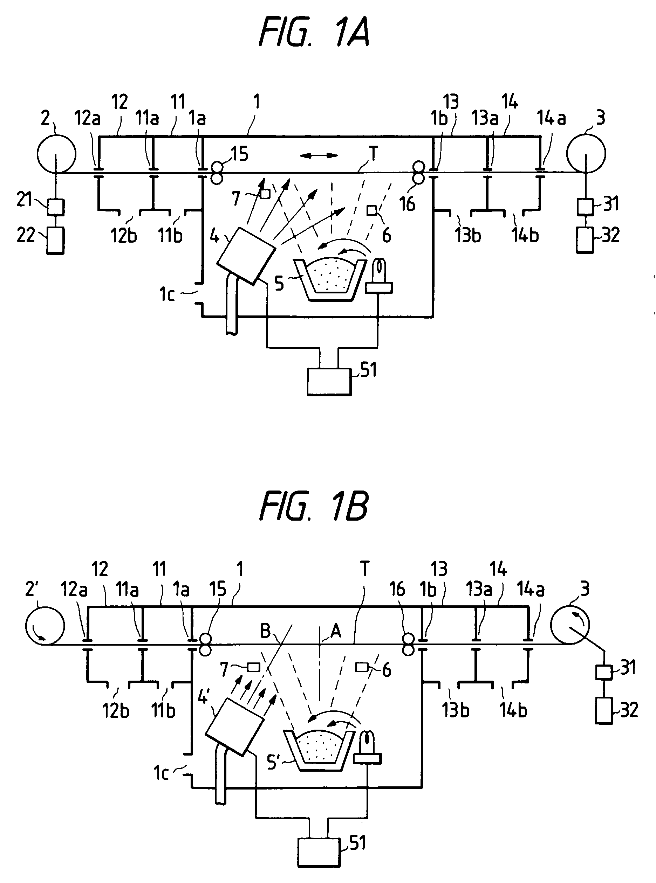

As shown in Fig. 1A, the film forming apparatus of the illustrated embodiment has a control film forming vacuum vessel 1. Auxiliary vacuum chambers 11 and 12 are successively connected to one side portion of the vessel 1 and a reel 2 is disposed outside of those chambers. Auxiliary vacuum chambers 13 and 14 are successively connected to the other side portion of the vessel 1. Further, a reel 3 is disposed outside the chambers 13 and 14.

A motor 22 is connected to the reel 2 through a disengageable coupling device 21 such as an electromagnetic clutch. A motor 32 is connected to the reel 3 through a coupling device 31 such as an electromagnetic clutch. The reel 2 can be driven to rotate in a clockwise direction as shown in the drawing by turning on the motor 22 and engagement of the coupling device 21. The reel 3 can be driven to rotate in counterclockwise direction by turning on the motor 32 and engagement of the coupling device 31.

Through-holes 12a, 14a, 11a, 13a, 1a and 1b, as small as possible to pass a strip-like substrate T extending between the reels 2 and 3, are provided in end walls of the auxiliary vacuum chambers 12 and 14, separating walls between the auxiliary vacuum chambers 11 and 12, and the auxiliary vacuum chambers 13 and 14, and separating walls between the auxiliary vacuum chambers 11 and 13 and the vacuum vessel 1, respectively. In the drawing, the reference numerals 15 and 16 designate separate pairs of guide rollers provided in the vessel 1 to guide the substrate.

Vacuum pump connection ports 1c, 11b, 12b, 13b and 14b are provided in the vacuum vessel 1 and the auxiliary vacuum chambers 11, 12, 13 and 14, respectively. A vacuum pump (not shown) is connected to the vacuum pump connection ports to evacuate the vessel 1 and the respective auxiliary chambers and to maintain the vessel 1 under a predetermined film forming vacuum.

In the vacuum vessel 1, an ion source 4 and an evaporation source 5 are disposed respectively on the side of the vessel near the reel 2 and on the side thereof near the reel 3. These sources face upward to the bottom surface of the substrate T supported for movement in a path by the reels 2 and 3.

The ion source 4 is capable of radiating an ion beam to the bottom surface of the substrate T. The evaporation source 5 is an electron beam evaporation source, preferably an EB evaporation source, though it is not limited thereto.

The ion source 4 and the evaporation source 5, in the embodiment of Fig. 1A, are disposed so that the center of a region, reached by the ion beam from the ion source 4 at the surface of the substrate T, substantially coincides with the center of a region to which evaporation particles from the evaporation source 5 are directed.

A film thickness monitor 6, for measuring the quantity of vapor deposition, is disposed to one side of the region reached by the evaporation material. A beam monitor 7, for measuring the quantity of ion radiation, is disposed to one side of the region to which ions are directed, and on the opposite side of the coincident region from the monitor 6.

The ion source 4 and the evaporation source 5 are connected to an ion radiation quantity and vapor deposition quantity control component 51, to which outputs (not shown) from the monitors 6 and 7 are inputted. On the basis of an instruction given by the control component, the ion source 4 supplies necessary and suitable ion radiation at the time of forming a mixture layer to be described, and the evaporation source 5 regulates the quantity of vapor deposition at one level during formation of the mixture layer and at a different level during the step of formation of an evaporation film on the mixture layer, as will also be described in more detail below. In operation of the aforementioned film forming apparatus embodiment, the method of the invention is carried out in the following manner.

A strip-like objective substrate T is preliminarily wound on the reel 2. A leading end of the substrate is passed through the holes 11a, 12a, 13a, 14a, 1a and 1b in the auxiliary vacuum chambers 11, 12, 13 and 14 and the vacuum vessel 1 and is connected to the other reel 3. In this condition, coupling device 21 for the reel 2 is disengaged, whereas the coupling device 31 for the reel 3 is engaged. The auxiliary vacuum chambers 11, 12, 13 and 14 and the vacuum vessel 1 are evacuated by a vacuum pump (not shown) so that the vacuum vessel 1 is maintained under a film forming vacuum of about 1X10⁻⁴ to about 1X10⁻² Pascal (about 1X10⁻⁶ to about 1X10⁻⁴ Torr).

While an evaporation material, such as a metal, preliminarily stored in the evaporation source 5, is evaporated from the evaporation source 5 to the surface of the substrate T and, at the same time, an ion beam of inert gas, such as argon gas, is radiated from the ion source 4 to the surface of the substrate T, the motor 32 for the reel 3 is operated to continuously move the substrate T in a predetermined direction and at a predetermined speed so that the substrate T is taken up on the reel 3 from the reel 2.

A mixture layer of constituent atoms of the material of the substrate T and constituent atoms of the evaporation material is thus continuously formed on the bottom surface of the substrate T by vacuum evaporation of the evaporation material onto the surface of the continuously moving substrate T and, at the same time, by ion radiation of the bottom surface.

In forming the mixture layer, the level of evaporation of the evaporation material and the level of ion radiation are adjusted by the control portion 51 to exhibit a transport ratio, that is, the ratio (M/N) of the number M of evaporation material atoms to the number N of ions reaching the surface of the substrate per unit time and per unit area, to obtain good layer adhesive quality with respect to the current density of the ion source 4. The ion type and energy at ion radiation, the transport ratio and the thickness of the mixture layer vary according to the kind of the evaporation material and the kind of the substrate, but it is preferable that the ion energy, the transport ratio (M/N) and the thickness of the mixture layer are about 500 eV to about 20 keV, about 1 to about 100 nm (about 10 to about 1000 Å) and about 10 to 300 nm (about 100 to 3000 Å), respectively. The mixture layer of good adhesive quality is formed on the substrate in this manner. If the transport ratio (M/N) is smaller than 10, that is, the rate of ion radiation is higher, the substrate becomes so damaged that adhesion deteriorates. If the transport rate is larger than 1000, or the rate of ion radiation is smaller, the resulting mixture layer is unsatisfactory.

After the mixture layer is roughly formed on a predetermined portion of the surface of the substrate T, the coupling device 31 for the reel 3 is disengaged and the coupling device 21 for the reel 2 is engaged. The motor 22 then operates to rewind the substrate T from the reel 3 to the reel 2 and to move the substrate T continuously in a direction opposite to the direction of movement during the mixture layer forming step. While the ion source 4 is deactivated during movement of the substrate T in the opposite direction, the evaporation source 5 is operated on the basis of an instruction given from the control component 51 at a level of evaporation to form a vacuum evaporation film of predetermined thickness on the mixture layer.

The vacuum evaporation film of predetermined thickness is continuously formed until finished on the mixture layer formed by the first step. The film thus formed on the substrate T is totally adhered to the substrate T because of the excellent adhesion of the mixture layer to the surface material of the substrate T. Moreover, the film is easily obtained at low cost by one ion source and one evaporation source. Also, in each of the two processing steps, the substrate T is fed continuously so that the efficiency in production of the film is good.

A specific example of film forming using the aforementioned apparatus will be described hereunder.
Substrate T: strip-like stainless steel plate
Feeding speed: 6m/min in each of the two steps
Evaporation material based on the evaporation source 5: aluminum
Film forming vacuum: 6.65X10⁻³ Pascal (5.0X10⁻⁵ Torr)
Speed of film forming from the evaporation source 5 during the mixture layer forming step: 50 nm/sec (500 Å/sec)
Speed of film forming from the evaporation source 5 onto the mixture layer: 200 nm/sec (2000 Å/sec)
Ion source 4:
   Ion type: Argon ion
   Energy: 2 KeV
   Beam current density: 0.8 mA/cm²
   Surface ion beam size at the substrate surface:
      150 mm in the substrate feeding direction,
      700 mm in the direction perpendicular thereto.
Transport ratio M/N in the mixture layer forming step:
   Al/Ar ion=60

An aluminum film was thus formed on the stainless steel plate with good adhesion, the thickness of the mixture layer and the thickness of the aluminum film being about 100 nm (1000 Å) and about 1µm, respectively.

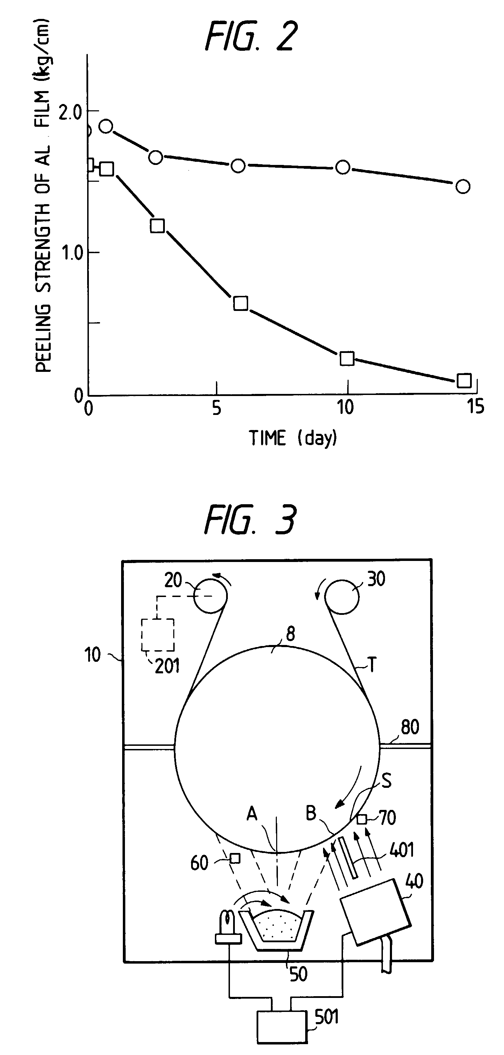

To provide a comparative test of the adhesion of the aluminum film formed by the aforementioned specific example, a stainless steel plate having an aluminum film was formed in the same manner as in the specific example, except that ion radiation for forming the mixture layer was not used. The two test specimens were exposed to a temperature of 150°C for an aluminum film peeling strength test according to JISC-5016 after a predetermined time had passed. The result of the test is shown in Fig. 2. In the graph of Fig. 2, the line expressed by the symbol △ shows the aluminum film in the specific example, and the line expressed by the symbol □ shows the aluminum film in the comparative example.

It is obvious from the results of the test that the adhesion of the aluminum film is reduced greatly with the passage of time in the comparative example, not using ion radiation for forming the mixture layer, whereas the adhesion of the aluminum film is maintained stable with the passage of time in the specific example according to the present invention, using ion radiation for forming the mixture layer.

It is to be understood that the present invention is not limited to the aforementioned apparatus embodiment and that it can be provided as variations thereof. For example, the reels 2 and 3 may be disposed in the vacuum vessel 1 and auxiliary vacuum chambers 11 to 14 may be omitted. Also, a part of ion radiation from the ion source 4 may be used for ion radiation in a pretreatment before the formation of the mixture layer. In this case, a part of ion radiation may be directed to a preliminary treatment region not reached by the evaporation particles.

A second embodiment of the film forming method according to the present invention and an embodiment of the film forming apparatus therefor will be described hereunder with reference to the Fig. 1B of the drawings, which schematically shows the film forming apparatus of the second embodiment.

The film forming apparatus in Fig. 1B is, with slight modification of previously described components, very similar to the embodiment of Fig. 1A. Thus, components in Fig. 1B which are identical to components in Fig. 1A are designated by the same reference numerals and will not be further described. Modified components in the embodiment of Fig. 1B are designated by primed reference numerals otherwise the same as those in Fig. 1A.

In the embodiment of Fig. 1B, the reel 2' is freely rotatable and, if necessary, provided with a braking or drag device for suppressing rotation due to inertia. As in the embodiment of Fig. 1A, the motor 32 is connected to the reel 3 through a coupling device 31 such as an electromagnetic clutch. The reel 3 can be driven to rotate counterclockwise in the drawing by turning on the motor 32 and by engagement of the coupling device 31.

Another modification of the embodiment of Fig. 1B, as compared with that of Fig. 1A, is that the ion source 4' and the evaporation source 5' are disposed so that the region, which the ion beam from the ion source 4' reaches at the surface of the substrate T, is shifted to the upstream side in the direction of feeding of the substrate relative to the region reached by the evaporation material from the evaporation source 5', that is to say, shifted to the upstream side of the evaporation region at which lower evaporation speeds are present.

In all other respects the structural organization of the embodiment of Fig. 1B is the same as Fig. 1A.

During operation of the film forming apparatus shown in Fig. 1B, a second method embodiment of the invention is carried out.

A strip-like objective substrate T is preliminarily wound on the reel 2. A leading end of the substrate is passed through the holes 11a, 12a, 13a, 14a, 1a and 1b in the auxiliary vacuum chambers 11, 12, 13 and 14 and the vacuum vessel 1 and is connected to the other reel 3. The auxiliary vacuum chambers 11, 12, 13 and 14 and the vacuum vessel 1 are evacuated by a vacuum pump (not shown) so that the vacuum vessel 1 is kept in a film forming vacuum of about 1X10⁻⁴ to about 1x10⁻² Pascal (about 1X10⁻⁶ to about 1X10⁻⁴ Torr).

Thereafter, while an evaporation material, such as a metal preliminarily stored in the evaporation source 5', is evaporated from the evaporation source 5' to the surface of the substrate T, at the same time an ion beam of inert gas, such as argon gas, is radiated from the ion source 4' to the surface of the substrate T. The motor 32 drives the reel 3 to continuously move the substrate T in a predetermined direction at a predetermined speed so that the substrate T is taken up by the reel 3 from the reel 2.

Vacuum evaporation of an evaporation material onto the bottom surface of the continuously moving substrate T, and radiation of ions from the ion source 4' are carried out simultaneously. In this embodiment, however, the ions from the source 4' are directed to a region displaced from the center portion of the evaporation region, or to a portion of the evaporation region receiving a relatively low level of evaporation material atoms. In other words, the region of ion radiation is at a portion of the evaporation region exhibiting a transport ratio M/N in which a mixture layer of good adhesion is formed. Thus, a mixture layer of constituent atoms of the substrate material and constituent atoms of the evaporation material is continuously formed on the surface of the substrate simultaneously with the continuous formation of a vacuum evaporation film of a predetermined thickness on the mixture layer. The evaporation material layer is formed at high speed by passing the mixture layer through the center portion of the evaporation region, which is higher in evaporation speed, and a lower evaporation material formation speed portion of that region following the center portion.

In the formation of the mixture layer in the second process embodiment, the radiation ion type and ion energy, the transport rate and the thickness of the mixture layer vary according to the kind of the material and the kind of the substrate, but it is preferable that the ion energy, the transport ratio (M/N) and the thickness of the mixture layer are in ranges of from about 500 eV to about 20 keV, from about 1 to about 100 nm (about 10 to about 1000 Å) and from about 10 to 300 nm (about 100 to 3000 Å), respectively. The control component 51 controls the ion source 4' and the evaporation source 5' to maintain these parameters respectively in the aforementioned ranges.

In each of the two steps, the substrate T is fed continuously so that good production efficiency is obtained. A specific example of film forming using the apparatus of Fig. 1B will now be described.
Substrate T: strip-like stainless steel plate
Feeding speed: 6m/min
Evaporation material based on the evaporation source 5: aluminum
Film forming vacuum: 6.65X10⁻³ Pascal 5.0X10⁻⁵ Torr)
Speed of film forming from the evaporation source 5': 200 nm/sec (2000 Å/sec)
   - Ion source 4:: This is disposed so that a center axial line of an ion beam electrode intersects the surface of the substrate at a position B shifted by 300 mm to the upstream side in the direction of movement of the substrate from a point A, the intersection between the center axial line of the evaporation source 5 and the surface of the substrate, as depicted in Fig. 1B.

The aluminum film formed by the second process embodiment was tested in the same manner as the method previously described with reference to Fig. 1A. The results were essentially the same and are thus also represented by the graph of Fig. 2 as explained above.

Another embodiment of the method according to the present invention and an embodiment of the film forming apparatus therefor will be described with reference to Fig. 3, which shows a schematic diagram of the film forming apparatus.

The film forming apparatus of Fig. 3 includes a film forming vacuum vessel 10 to which a vacuum pump (not shown) is connected to maintain the vessel 10 under a predetermined vacuum.

Reels 20 and 30 are disposed in an upper portion of the vessel 10. The reel 20 is arranged to be driven to rotate counterclockwise in the drawing by a motor 201 provided outside the vessel 10. The reel 30 freely rotates, but, if necessary, a braking device for suppressing inertial rotation may be provided.

A guide drum 8, freely rotatable, is provided in the center portion of the vessel 10 so that the strip-like substrate T to be taken up from the reel 30 to the reel 20 can be supported and guided by the circumference of the guide drum 8.

An evaporation source 50 is disposed in the lower portion of the vacuum vessel 10 and directly under the drum 8. An ion source 40 is disposed to one side upstream of the evaporation source 50 and generally under the reel 30. Further, a partition plate 80 is provided at opposite sides of the drum 8 to prevent the evaporation material and ions from entering into the chamber containing the reels 20 and 30.

The ion source 40 and the evaporation source 50 are essentially the same as those previously described.

The ion source 40 and the evaporation source 50 are disposed so that the region to which the ion beam from the ion source 40 reaches the surface of the substrate T guided by the drum 8 is shifted to the upstream side, in the direction of substrate feed, from the center portion of the region reached by the evaporation material from the evaporation source 50. Thus the region reached by the ion beam is shifted to the upstream portion of the evaporation region which is lower in evaporation speed, and so that a part (in this embodiment, about one half) of the ion beam is radiated to an ion radiation pre-treatment region S adjacent to the upstream side of the evaporation material arrival region in the direction of feeding of the substrate. A deposition preventing plate 401 is provided in the vicinity of the position B of intersection between the center of the ion beam and the surface of the substrate T on the guide drum 8 to prevent the evaporation material front depositing on the pre-treatment region.

A film thickness monitor 60 for measuring the quantity of vapor deposition is disposed at a part of the region reached by the evaporation material. A beam monitor 70 for measuring the quantity of ion radiation is disposed at a part of the region reached by ions.

The ion source 40 and the evaporation source 50 are connected to an ion radiation quantity and vapor deposition quantity control component 501, to which outputs (not shown) from the monitors 60 and 70 are inputted. On the basis of an instruction given by the control component, the ion source 40 performs suitable ion radiation necessary for the pre-treatment and for the formation of the mixture layer. The evaporation source 50 evaporates the evaporative material at a rate to achieve the quantity of vapor deposition necessary for forming the mixture layer and then for forming a vacuum evaporation film on the mixture layer.

The strip-like objective substrate T is preliminarily wound on the reel 30. Then, a leading end of the substrate is wound on the circumference of the guide drum 8 and is connected to the other reel 20.

The vacuum vessel 10 is evacuated by a vacuum pump not shown so that the vacuum vessel 10 is kept in a film forming vacuum of about 1X10⁻⁴ to about 1x10⁻² Pascal (about 1X10⁻⁶ to about 1X10⁻⁴ Torr).

Then, while the evaporative material, such as a metal preliminarily stored in the evaporation source 50, is evaporated from the evaporation source 50 to the surface of the substrate T on the drum 8 and, at the same time, an ion beam of inert gas, such as argon gas, is radiated from the ion source 40 to the surface of the substrate T, the reel 20 is driven by the motor 201 to continuously move the substrate T in a predetermined direction at a predetermined speed so that the substrate T is taken up by the reel 20 from the reel 30.

Vacuum evaporation of the evaporation material is directed to an evaporation region on the surface of the continuously moving substrate T and radiation of ions is directed to a lower evaporation speed portion out of the center portion of the evaporation region, or a portion having a relatively lower rate of evaporation material atom arrival. In other words, the ions are directed to a portion of the evaporation region exhibiting a transport rate M/N in which a good adhesive mixture layer is formed, simultaneously with radiation of ions to the surface of the substrate in the more upstream pretreatment region S.

The pre-treatment step, such as for activating of the substrate surface and cleaning to remove water, is thus carried out by ion radiation of the surface of the continuously moving substrate. Then, a mixture layer of constituent atoms of the substrate material and constituent atoms of the evaporation material is continuously formed on the pretreated substrate surface. Then the mixture layer is made to pass through the center portion of the evaporation region, high in evaporation speed, and through a portion after the center portion, so that a vacuum evaporation film with a predetermined thickness is continuously formed on the mixture layer at a high film forming speed.

In the formation of the mixture layer, the radiation ion type and ion energy, the transport rate and the thickness of the mixture layer vary according to the kind of the material and the kind of the substrate, but it is preferable also in this case that the ion energy, the transport rate (M/N) and the thickness of the mixture layer are in ranges of from about 500 eV to about 20 keV, from about 1 to about 100 nm (about 10 to about 1000 Å) and from about 10 to 300 nm (about 100 to 3000 Å), respectively. The control portion 501 controls the ion source 40 and the evaporation source 50 to maintain these parameters respectively in the aforementioned ranges.

The vacuum evaporation film with the predetermined thickness is continuously formed on the mixture layer preliminarily formed, so that film forming is finished.

The film thus formed on the substrate T is totally adhered to the substrate T, because of the formation of the mixture layer on the surface of the substrate material after the pre-treatment step. Also, the film is obtained easily and at low cost by successively carrying out the pre-treatment, the formation of the mixture layer and the formation of the vacuum evaporation film, using a single ion source and a single evaporation source as described above. Further, good production efficiency is attained.

A specific example of film forming using the apparatus in Fig. 3 will now be described.
Substrate T: Polyimide film
Feeding speed: 6m/min
Evaporation material from the evaporation source 50: aluminum
Film forming vacuum: 6.65x10⁻³ Pascal (5.0x10⁻⁵ Torr)
Speed of film forming from the evaporation source 50: 200nm/sec (2000 Å/sec)
   - Ion source 40:: This is disposed so that a center axial line of an ion beam electrode intersects the surface of the substrate at a position B, as shown in Fig. 3, shifted by 300 mm to the upstream side in the direction of movement of the substrate from a point A of intersection between the center axial line of the evaporation source between the center axial line of the evaporation source 50 and the surface of the substrate and so that about one half of the surface ion beam is used for the pre-treatment.
   Ion type: Argon ion
   Energy: 2 keV
   Beam current density: 0.8 mA/cm².
   Surface ion beam size at the substrate surface:
   250 mm in the substrate feeding direction,
   700 mm in a direction perpendicular thereto.
   Transport rate M/N for forming the mixture layer: Al/Ar ion=80

A metallized film was thus obtained by forming an aluminum film of good adhesion on the polyimide film substrate T so that the thickness of the mixture layer and the thickness of the Al film were about 100 nm (1000 Å) and about 1 µm, respectively. The high adhesion of the film was kept stable by application of the pretreatment using ion radiation, so that lowering of the adhesion of the aluminum film was not observed in the heat history (for example, from -30°C to 130°C) in a film strength test and the like.

To test the adhesion of the aluminum film, a comparative example was prepared with a polyimide film having an aluminum film formed in the same manner as in the aforementioned specific example except that a member (not shown) for preventing ion radiation to the pre-treatment region was used in the apparatus in to heat cycles (about one cycle per day) of -30°C to 130°C to be subjected to an aluminum film peeling strength test according to JISC-5016 after a predetermined time passed. The results of the test are shown in Fig. 4. In the graph of Fig. 4, the line expressed by the symbol △ shows the aluminum film in the specific example, and the line expressed by the symbol □ shows the aluminum film in the comparative example.

As is obvious from the results of the test, the adhesion of the aluminum film is reduced with the passage of time in the comparative example not using the ion radiation pre-treatment, whereas the adhesion of the aluminum film is higher and kept stable regardless of the passage of time in the specific example of the present invention using the ion radiation pretreatment.

It is to be understood that the present invention is not limited to the aforementioned embodiment and that it can be provided as various embodiments thereof. In the apparatus in Fig. 3 and the method of the invention using that apparatus, the reels 20 and 30 may be disposed outside the vacuum vessel 10 in the same manner as in the apparatus in Fig. 1B. In this case, if necessary, auxiliary vacuum chambers as in the apparatus in Figs. 1A and 1B may be provided. Further, in the apparatus of Fig. 3, the deposition preventing plate 401 is not always necessary. Also in the apparatus of Fig. 1B, a part of the ion beam may be used for the pre-treatment and, further, a deposition preventing plate having the same function as the deposition preventing plate 401 having the same function as the deposition preventing plate 401 may be provided.

As described above, according to the present invention, a film forming method and a film forming apparatus can be provided in which a film can be continuously formed on a substrate easily, at low cost, and good in adhesion compared to the conventional method and apparatus.

The foregoing description of preferred embodiments of the invention has been presented for purposes of illustration and description. It is not intended to be exhaustive or to limit the invention to the precise form disclosed, and modifications and variations are possible in light of the above teachings or may be acquired from practice of the invention. The embodiments were chosen and described in order to explain the principles of the invention and its practical application to enable one skilled in the art to utilize the invention in various embodiments and with various modifications as are suited to the particular use contemplated. It is intended that the scope of the invention be defined by the claims appended hereto.

## Claims

1. A method for forming a film of an evaporation material on a substrate (T), said method comprising the steps of:
forming a mixture layer on a surface of the substrate (T), the mixture layer including atoms of both the substrate material and the evaporation material, by vacuum evaporation of a predetermined amount of evaporation material from an evaporation source (5) to said surface and radiation of ions to said surface during movement of said substrate (T) in a predetermined direction;
and forming a film with a predetermined thickness of the evaporation material on said mixture layer from the evaporation source (5) by vacuum evaporation, while said substrate (T) is continuously moved;
**characterized by**
the film with a predetermined thickness of evaporation material being formed with the same evaporation source used for forming said mixture layer after said mixture layer has been at least partially formed on a predetermined portion of said surface of said substrate (T), during movement of the substrate in a direction the same or opposite said predetermined direction with respect to said evaporation source (5);
the center of the region reached by the ion irradiation at the surface of the substrate (T), substantially coinciding with the center of the region to which evaporation particles from the evaporation source (5) are directed; and
the ion irradiation and said evaporation being adjusted independently, whereby
said ion irradiation for forming said mixture layer is carried out so that the ratio M/N of the number M of evaporation material atoms to the number N of ions reaching said surface of said substrate (T) per unit time and per unit area is in a range of from 10 to 1000.

2. A method for forming a film of an evaporation material on a substrate (T), said method comprising the steps of:
forming a mixture layer on a surface of the substrate (T), the mixture layer including atoms of both the substrate material and the evaporation material, by vacuum evaporation of a predetermined amount of evaporation material from an evaporation source (5',50) to said surface and radiation of ions to said surface during movement of said substrate (T) in a predetermined direction;
and forming a film with a predetermined thickness of the evaporation material on said mixture layer from an evaporation source (5',50) by vacuum evaporation, while said substrate (T) is continuously moved;
**characterized by**
said ion irradiation and said vacuum evaporation of a predetermined amount of the evaporating material from an evaporating source (5',50) onto said substrate (T) being carried out at the same time while continuously moving said substrate (T), said ion irradiation being applied to a portion (B) located upstream, relative to the direction of substrate movement, from a central part (A) of the region reached by evaporation of the evaporation material from said evaporation source (5',50), evaporation speed being lower in the upstream portion (B) than at the central part (A) of said region, so that a mixture layer of atoms of the substrate and the evaporation material is formed continuously on said surface of said substrate at the portion (B) where the ion irradiation is applied; and
said vacuum evaporation film with predetermined thickness of the evaporation material being formed continuously on said mixture layer at the portion (A) where the ion irradiation is not applied;
said ion irradiation and said evaporation being adjusted independently, whereby
said ion irradiation for forming said mixture layer is carried out so that the ratio M/N of the number N of the evaporation material atoms to the number N ions reaching said surface of said substrate (T) per unit time and per unit area is in the range of from 10 to 1000.

3. The film forming method according to claim 2, in which a part of said ion radiation is simultaneously applied to an added upstream portion of the substrate located outside said region reached by the evaporation of the evaporation material from said evaporation source, so that said surface of said substrate is pretreated before the formation of said mixture layer.

4. A film forming apparatus comprising:
an evaporation source (5) for vacuum evaporation of a predetermined material onto the surface of a moving objective substrate (T);
an ion source (4) for radiating ions toward the surface of said moving substrate (T);
means (2,20,3,30) for continuously moving said objective substrate (T), said means (2,20,3,30) being arranged to move said substrate (T) in a predetermined direction;
to in use form a mixture layer on a surface of the substrate (T), the mixture layer including atoms of both the substrate material and the evaporation material, by vacuum evaporation of a predetermined amount of evaporation material from the evaporation source (5) to said surface and radiation of ions from said ion source (4) to said surface during movement of said substrate (T) in said predetermined direction;
to in use form a film with predetermined thickness of the evaporation material on said mixture layer from the same evaporation source (5) by vacuum evaporation, while said substrate (T) is continuously moved;
**characterized by**
the moving means (2,3) being arranged to in use move said substrate in a predetermined direction in a step of forming a mixture layer of substrate material atoms and evaporation material atoms from said evaporation source (5) and to move said substrate in the direction the same as or opposite to said predetermined direction in case of forming said mixture layer in another step of forming a film with a predetermined thickness of said evaporation source (5) on said mixture layer by vacuum evaporation;
said ion source (4) and said evaporation source (5) are disposed so that the center of the region in use reached by the ion beam form the ion source (4) at the surface of the substrate (T), substantially coincides with the center of the region to which evaporation particles from the evaporation source (5) are directed; and
said ion source (4) arranged to be operated independently of the evaporation source (5), such that in use,
said ion irradiation from said ion source (4) for forming said mixture layer can be carried out so that the ratio M/N of the number M of evaporation material atoms to the number N of ions reaching said surface of said substrate (T) per unit time and per unit area is in a range of from 10 to 1000.

5. A film forming apparatus comprising:
an evaporation source (5',50) for vacuum evaporation of a predetermined material onto the surface of a moving objective substrate (T);
an ion source (4',40) for radiating ions toward the surface of said moving substrate (T);
means (2,20,3,30) for continuously moving said objective substrate (T), in a predetermined direction;
to in use form a mixture layer on a surface of the substrate (T), the mixture layer including atoms of both the substrate material and the evaporation material, by vacuum evaporation of a predetermined amount of evaporation material from the evaporation source (5',50) to said surface and radiation of ions from said ion source (4',40) to said surface during movement of said substrate (T) in said predetermined direction;
to in use form a film with predetermined thickness of the evaporation material on said mixture layer from the same evaporation source (5',50) by vacuum evaporation, while said substrate (T) is continuously moved;
**characterized by**
said irradiation from the ion source (4',40) and the vacuum evaporation of a predetermined amount of the evaporation material from the evaporation source (5',50) onto said substrate (T) in use being carried out at the same time, while continuously moving said substrate, said ion source (4',40) being disposed so that said ion radiation from said ion source (4',40) is in use applied to a portion (B), located upstream from a central portion (A) in the direction of movement of said substrate which upstream portion (B) is lower in evaporation speed than the central portion (A) so that a mixture layer of substrate material atoms and evaporation material atoms is continuously formed on said surface of said substrate (T) at the portion (B) where the ion irradiation is applied, and then a vacuum evaporation film with a predetermined thickness is continuously formed on said mixture layer at the portion (A) where the ion irradiation is not applied, and
said ion source (4',40) can be operated independently from said evaporation source (5,50') such that in use
said ion irradiation from ion source (4',40) for forming said mixture layer can be carried out so that the ratio M/N of the number N of evaporation material atoms to the number N of ions reaching said surface of said substrate (T) per unit time and per unit area is in a range of from 10 to 1000.

6. A film forming apparatus according to claim 5, in which said ion source is disposed so that in use a part of said ion radiation is simultaneously applied to the substrate surface upstream from said surface region reached by the evaporation material from said evaporation source, whereby said surface of said substrate is pretreated before the formation of said mixture layer.

## Patentansprüche

1. Verfahren zur Bildung einer Dünnschicht aus einem Aufdampfmaterial auf einem Substrat (T), wobei das Verfahren die folgenden Schritte umfaßt:
Bilden einer gemischten Schicht auf einer Oberfläche des Substrats (T), wobei die gemischte Schicht Atome sowohl des Substratmaterials als auch des Aufdampfmaterials umfaßt, durch Vakuumaufdampfen einer vorbestimmten Menge von Aufdampfmaterial aus einer Aufdampfquelle (5) auf die Oberfläche und Bestrahlung der Oberfläche mit Ionen während der Bewegung des Substrats (T) in einer vorbestimmten Richtung;
und Bilden einer Dünnschicht aus Aufdampfmaterial mit einer vorbestimmten Dicke auf der gemischten Schicht aus einer Aufdampfquelle (5) durch Vakuumaufdampfen, während das Substrat (T) kontinuierlich bewegt wird;
**dadurch gekennzeichnet**, daß
die Dünnschicht mit einer vorbestimmten Dicke aus Aufdampfmaterial mit derselben Aufdampfquelle gebildet wird, die zur Bildung der gemischten Schicht benutzt wird, nachdem die gemischte Schicht zumindest teilweise auf einem vorbestimmten Teil der Oberfläche des Substrats (T) gebildet worden ist, während sich das Substrat in der gleichen Richtung oder entgegengesetzt zu der vorbestimmten Richtung bezüglich der Aufdampfquelle (5) bewegt;
das Zentrum des Bereichs, der von der Ionenbestrahlung an der Oberfläche des Substrats (T) erreicht wird, im wesentlichen mit dem Zentrum des Bereichs übereinstimmt, auf den die Aufdampfteilchen aus der Aufdampfquelle (5) gerichtet sind; und
die Ionenbestrahlung und die Verdampfung unabhängig eingestellt werden, wobei
die Ionenbestrahlung zur Bildung der gemischten Schicht derart ausgeführt wird, daß das Verhältnis M/N der Anzahl M von Aufdampfmaterialatomen zu der Anzahl N von Ionen, die die Oberfläche des Substrats (T) pro Zeiteinheit und pro Flächeneinheit erreichen, im Bereich von 10 bis 1000 ist.

2. Verfahren zur Bildung einer Dünnschicht aus Aufdampfmaterial auf einem Substrat (T), wobei das Verfahren die folgenden Schritte aufweist:
Bildung einer gemischten Schicht auf einer Oberfläche des Substrats (T), wobei die gemischte Schicht sowohl Atome des Substratmaterials als auch des Aufdampfmaterials umfaßt, durch Vakuumaufdampfen einer vorbestimmten Menge von Aufdampfmaterial aus einer Aufdampfquelle (5', 50) auf die Oberfläche und Bestrahlung der Oberfläche mit Ionen während sich das Substrat (T) in einer vorbestimmten Richtung bewegt;
und Bildung einer Dünnschicht aus Aufdampfmaterial mit einer vorbestimmten Dicke auf der gemischten Schicht aus einer Aufdampfquelle (5',50) durch Vakuumaufdampfen, während das Substrat (T) kontinuierlich bewegt wird;
**dadurch gekennzeichnet**, daß
die Ionenbestrahlung und das Vakuumaufdampfen einer vorbestimmten Menge von Aufdampfmaterial aus einer Aufdampfquelle (5',50) auf das Substrat (T) gleichzeitig ausgeführt werden, während das Substrat (T) kontinuierlich bewegt wird, wobei die Ionenbestrahlung auf einen Teilbereich (B) angewendet wird, der - relativ zur Bewegungsrichtung des Substrats - gegenüber einem zentralen Teil (A) des Bereichs, der von der Verdampfung des Aufdampfmaterials aus der Aufdampfquelle (5',50) erreicht wird, stromaufwärts liegt und die Verdampfungsgeschwindigkeit in dem stromaufwärtigen Teilbereich (B) geringer ist als in dem zentralen Teil (A) des Bereichs, so daß eine gemischte Schicht aus Atomen des Substrats und des Aufdampfmaterials kontinuierlich auf der Oberfläche des Substrats an dem Teilbereich (B) gebildet wird, wo die Ionenbestrahlung angewendet wird; und
die Vakuumaufdampfschicht mit einer vorbestimmten Dicke aus Aufdampfmaterial kontinuierlich auf der gemischten Schicht an dem Teilbereich (A) gebildet wird, wo die Ionenbestrahlung nicht angewendet wird;
die Ionenbestrahlung und die Verdampfung unabhängig voneinander eingestellt werden, wobei
die Ionenbestrahlung zur Bildung der gemischten Schicht derart ausgeführt wird, daß das Verhältnis M/N der Anzahl M von Aufdampfmaterialatomen zu der Anzahl N von Ionen, die die Oberfläche des Substrats (T) pro Zeiteinheit und pro Flächeneinheit erreichen, im Bereich von 10 bis 1000 ist.

3. Dünnschichtbildungsverfahren nach Anspruch 2, in dem ein Teil der Ionenbestrahlung simultan auf einen zusätzlichen stromaufwärtigen Teilbereich des Substrats angewendet wird, der außerhalb des Bereichs liegt, der von der Verdampfung von Aufdampfmaterial aus der Aufdampfquelle erreicht wird, so daß die Oberfläche des Substrats vor der Bildung der gemischten Schicht vorbehandelt wird.

4. Vorrichtung zur Bildung von Dünnschichten, die folgendes umfaßt:
eine Aufdampfquelle (5) zum Vakuumaufdampfen eines vorbestimmten Materials auf die Oberfläche eines sich bewegenden Zielsubstrats (T);
eine Ionenquelle (4) zur Strahlung von Ionen zu der Oberfläche des sich bewegenden Substrats (T);
Mittel (2,20,3,30) zur kontinuierlichen Bewegung des Zielsubstrats (T), wobei die Mittel (2,20,3,30) zur Bewegung des Substrats (T) in einer vorbestimmten Richtung angeordnet sind;
um beim Gebrauch eine gemischte Schicht auf einer Oberfläche des Substrats (T) zu bilden, wobei die gemischte Schicht Atome sowohl des Substratmaterials als auch des Aufdampfmaterials umfaßt, durch Vakuumaufdampfen einer vorbestimmten Menge von Aufdampfmaterial aus der Aufdampfquelle (5) auf die Oberfläche und Bestrahlung der Oberfläche mit Ionen aus der Ionenquelle (4) während der Bewegung des Substrats (T) in der vorbestimmten Richtung;
um beim Gebrauch eine Dünnschicht aus Aufdampfmaterial mit vorbestimmter Dicke auf der gemischten Schicht aus derselben Aufdampfquelle (5) durch Vakuumverdampfung zu bilden, während das Substrat (T) kontinuierlich bewegt wird;
**dadurch gekennzeichnet**, daß
die Bewegungsmittel (2,3) angeordnet sind, um beim Gebrauch das Substrat bei einem Schritt der Bildung einer gemischten Schicht von Substratmaterialatomen und Aufdampfmaterialatomen aus der Aufdampfmaterial (5) in einer vorbestimmten Richtung zu bewegen und das Substrat in einem anderen Schritt der Bildung einer Dünnschicht mit einer vorbestimmten Dicke aus der Aufdampfquelle (5) auf der gemischten Schicht durch Vakuumverdampfung in der gleichen Richtung wie die vorbestimmte Richtung beim Bilden der gemischten Schicht oder entgegengesetzt dazu zu bewegen;
die Ionenquelle (4) und die Aufdampfquelle (5) so angeordnet sind, daß das Zentrum des Bereichs, der beim Gebrauch von dem Ionenstrahl aus der Ionenquelle (4) an der Oberfläche des Substrats (T) erreicht wird, im wesentlichen mit dem Zentrum des Bereichs übereinstimmt, auf den die Aufdampfteilchen aus der Aufdampfquelle (5) gerichtet sind; und
die Ionenquelle (4) so aufgebaut ist, daß sie unabhängig von der Aufdampfquelle (5) betrieben wird, so daß im Gebrauch,
die Ionenbestrahlung aus der Ionenquelle (4) zur Bildung der gemischten Schicht so ausgeführt werden kann, daß das Verhältnis M/N der Anzahl M von Aufdampfmaterialatomen zu der Anzahl N von Ionen, die die Oberfläche des Substrats (T) pro Zeiteinheit und pro Flächeneinheit erreichen, im Bereich von 10 bis 1000 ist.

5. Vorrichtung zur Bildung von Dünnschichten, die folgendes umfaßt:
eine Aufdampfquelle (5',50) zur Vakuumverdampfung eines vorbestimmten Materials auf die Oberfläche eines sich bewegenden Zielsubstrats (T);
einen Ionenquelle (4',40) zur Strahlung von Ionen zu der Oberfläche des sich bewegenden Substrats (T);
Mittel (2,20,3,30) zur kontinuierlichen Bewegung des Zielsubstrats (T) in einer vorbestimmten Richtung;
um beim Gebrauch eine gemischte Schicht auf einer Oberfläche des Substrats (T) zu bilden, wobei die gemischte Schicht Atome sowohl des Substratmaterials als auch des Verdampfungsmaterials umfaßt, durch Vakuumverdampfung einer vorbestimmten Menge von Aufdampfmaterial aus der Aufdampfquelle (5',50) zu der Oberfläche und Bestrahlung der Oberfläche mit Ionen aus der Ionenquelle (4',40) während der Bewegung des Substrats (T) in der vorbestimmten Richtung;
um beim Gebrauch eine Dünnschicht aus Aufdampfmaterial mit vorbestimmter Dicke auf der gemischten Schicht durch Vakuumverdampfung aus der Aufdampfquelle (5',50) zu bilden, während das Substrat (T) kontinuierlich bewegt wird;
**dadurch gekennzeichnet**, daß
die Bestrahlung aus der Ionenquelle (4',40) und die Vakuumverdampfung einer vorbestimmten Menge von Aufdampfmaterial aus der Aufdampfquelle (5',50) auf die Oberfläche (T) beim Gebrauch gleichzeitig ausgeführt werden, während das Substrat kontinuierlich bewegt wird, wobei die Ionenquelle (4',40) so angeordnet ist, daß die Ionenbestrahlung aus der Ionenquelle (4',40) beim Gebrauch auf einen Teilbereich (B) angewendet wird, der - in Richtung der Bewegung des Substrats - gegenüber einem zentralen Teilbereich (A) stromaufwärts angeordnet ist und die Aufdampfgeschwindigkeit in dem stromaufwärtigen Bereich (B) geringer ist als in dem zentralen Teilbereich (A), so daß eine gemischte Schicht aus Substratmaterialatomen und Aufdampfmaterialatomen kontinuierlich auf der Oberfläche des Substrats (T) an dem Teilbereich (B) gebildet wird, wo die Ionenbestrahlung angewendet wird, und dann eine Vakuumaufdampfschicht mit einer vorbestimmten Dicke kontinuierlich auf der gemischten Schicht an dem Bereich (A) gebildet wird, wo die Ionenbestrahlung nicht angewendet wird, und die Ionenquelle (4',40) unabhängig von der Aufdampfquelle (5',50) betrieben werden kann, so daß beim Gebrauch
die Ionenbestrahlung aus der Ionenquelle (4',40) zur Bildung der gemischten Schicht derart ausgeführt werden kann, daß das Verhältnis M/N der Anzahl M von Aufdampfmaterialatomen zu der Anzahl N von Ionen, die die Oberfläche des Substrats (T) pro Zeiteinheit und pro Flächeneinheit erreichen, im Bereich von 10 bis 1000 ist.

6. Vorrichtung zur Bildung von Dünnschichten nach Anspruch 5, bei der die Ionenquelle so angeordnet ist, daß im Gebrauch ein Teil der Ionenstrahlung simultan auf die Substratoberfläche angewendet wird, die stromaufwärts von dem Oberflächenbereich liegt, der von dem Aufdampfmaterial aus der Aufdampfquelle erreicht wird, wodurch die Oberfläche des Substrats vor der Bildung der gemischten Schicht vorbehandelt wird.

## Revendications

1. Procédé de formation d'un film d'une matière évaporée sur un substrat (T), le procédé comprenant les étapes suivantes :
la formation d'une couche de mélange sur une surface du substrat (T), la couche de mélange contenant des atomes à la fois de la matière du substrat et de la matière évaporée, par évaporation sous vide d'une quantité prédéterminée d'une matière d'évaporation d'une source (5) d'évaporation vers la surface et irradiation par des ions vers la surface lors du déplacement du substrat (T) dans un sens prédéterminé, et
la formation d'un film d'épaisseur prédéterminée de la matière d'évaporation sur la couche de mélange à partir de la source (5) d'évaporation par évaporation sous vide, alors que le substrat (T) se déplace de façon continue,
caractérisé en ce que :
le film ayant l'épaisseur prédéterminée, formé de la matière d'évaporation, est réalisé avec la source d'évaporation déjà utilisée pour la formation de la couche de mélange après que la couche de mélange a été formée au moins partiellement sur la partie prédéterminée de la surface du substrat (T) pendant le déplacement du substrat dans le sens prédéterminé ou le sens opposé, par rapport à la source d'évaporation (5),
le centre de la région atteinte par l'irradiation par des ions à la surface du substrat (T) coïncide pratiquement avec le centre de la région dans laquelle sont dirigées les particules évaporées provenant de la source d'évaporation (5), et
l'irradiation par des ions et l'évaporation sont réglées indépendamment,
si bien que l'irradiation par des ions destinée à former la couche de mélange est réalisée de manière que le rapport M/N du nombre M d'atomes de la matière évaporée au nombre N d'ions atteignant la surface du substrat (T) par unité de temps et par unité de surface soit compris entre 10 et 1 000.

2. Procédé de formation d'un film d'une matière d'évaporation sur un substrat (T), le procédé comprenant les étapes suivantes :
la formation d'une couche de mélange sur une surface d'un substrat (T), la couche de mélange contenant des atomes de la matière du substrat et de la matière d'évaporation, par évaporation sous vide d'une quantité prédéterminée de la matière d'évaporation d'une source d'évaporation (5', 50) vers la surface et irradiation de la surface par des ions pendant le déplacement du substrat (T) dans un sens prédéterminé, et
la formation d'un film d'épaisseur prédéterminée de la matière d'évaporation sur la couche de mélange à partir d'une source d'évaporation (5', 50) par évaporation sous vide, lorsque le substrat (T) se déplace de façon continue,
caractérisé en ce que :
l'irradiation par des ions et l'évaporation sous vide d'une quantité prédéterminée de la matière d'évaporation d'une source d'évaporation (5', 50) sur le substrat (T) sont réalisées en même temps avec déplacement continu du substrat (T), l'irradiation par des ions étant appliquée à une partie (B) qui se trouve, dans le sens de déplacement du substrat, en amont d'une partie centrale (A) de la région atteinte par l'évaporation de la matière d'évaporation de la source d'évaporation (5', 50), la vitesse d'évaporation étant plus faible dans la partie amont (B) que dans la partie centrale (A) de ladite région, si bien qu'une couche de mélange d'atomes du substrat et de la matière d'évaporation se forme de façon continue à la surface du substrat dans la partie (B) dans laquelle est appliquée l'irradiation par les ions,
le film d'évaporation sous vide d'épaisseur prédéterminée de la matière d'évaporation est formé de façon continue sur la couche de mélange dans la partie (A) dans laquelle l'irradiation par des ions n'est pas appliquée, et
l'irradiation par des ions et l'évaporation sont ajustées indépendamment,
si bien que l'irradiation par des ions destinée à former la couche de mélange est réalisée de manière que le rapport M/N du nombre M d'atomes de la matière d'évaporation au nombre N d'ions atteignant la surface du substrat (T) par unité de temps et par unité de surface soit compris entre 10 et 1 000.

3. Procédé de formation de film selon la revendication 2, dans lequel une partie du rayonnement par des ions est appliquée simultanément à une partie supplémentaire en amont du substrat en dehors de la région atteinte par évaporation de la matière d'évaporation de la source d'évaporation, si bien que la surface du substrat subit un traitement préalable à la formation de la couche de mélange.

4. Appareil de formation de film, comprenant :
une source d'évaporation (5) destinée à l'évaporation sous vide d'une matière prédéterminée à la surface d'un substrat mobile (T) formant un objet,
une source d'ions (4) destinée à émettre des ions vers la surface du substrat mobile (T),
un dispositif (2, 20, 3, 30) de déplacement continu du substrat (T) constituant l'objet, ce dispositif (2, 20, 3, 30) étant destiné à déplacer le substrat (T) dans un sens prédéterminé
pour la formation, pendant l'utilisation, d'une couche de mélange sur une surface du substrat (T), la couche de mélange comprenant des atomes de la matière du substrat et de la matière évaporée, par évaporation sous vide d'une quantité prédéterminée d'une matière d'évaporation de la source d'évaporation (5) à la surface et irradiation par des ions de la source d'ions (4) de ladite surface lors du déplacement du substrat (T) dans le sens prédéterminé,
pour la formation, pendant l'utilisation, d'un film d'épaisseur prédéterminée de la matière d'évaporation sur la couche de mélange à partir de la même source d'évaporation (5) par évaporation sous vide, alors que le substrat (T) se déplace de façon continue,
caractérisé en ce que :
le dispositif de déplacement (2, 3) est disposé afin que, pendant l'utilisation, il déplace le substrat dans un sens prédéterminé dans une étape de formation d'une couche de mélange d'atomes de la matière du substrat et d'atomes de la matière d'évaporation de la source d'évaporation (5), et qu'il déplace le substrat dans le sens prédéterminé ou en sens opposé dans le cas de la formation de la couche de mélange dans une autre étape de formation d'un film avec une épaisseur prédéterminée de la source d'évaporation (5) sur la couche de mélange par évaporation sous vide,
la source d'ions (4) et la source d'évaporation (5) sont disposées de manière que le centre de la région atteinte, pendant l'utilisation, par le faisceau d'ions formé par la source d'ions (4) à la surface du substrat (T) coïncide pratiquement avec le centre de la région vers laquelle sont dirigées les particules évaporées de la source d'évaporation (5), et
la source d'ions (4) est disposée afin qu'elle fonctionne indépendamment de la source d'évaporation (5), d'une manière telle que, pendant le fonctionnement,
l'irradiation par les ions de la source d'ions (4) destinée à former la couche de mélange peut être réalisée de manière que le rapport M/N du nombre M d'atomes de la matière d'évaporation au nombre N d'ions atteignant la surface du substrat (T) par unité de temps et unité de surface soit compris entre 10 et 1 000.

5. Appareil de formation de film, comprenant :
une source d'évaporation (5', 50) destinée à l'évaporation sous vide d'une matière prédéterminée à la surface d'un substrat mobile (T) formant un objet,
une source d'ions (4', 40) destinée à émettre des ions vers la surface du substrat mobile (T),
un dispositif (2, 20, 3, 30) de déplacement continu du substrat (T) formant l'objet, dans un sens prédéterminé,
afin que, pendant l'utilisation, une couche de mélange soit formée sur une surface du substrat (T), la couche de mélange contenant des atomes à la fois de la matière du substrat et de la matière évaporée, par évaporation sous vide d'une quantité prédéterminée de matière d'évaporation de la source d'évaporation (5', 50) à la surface et irradiation de ladite surface par des ions de la source d'ions (4', 40) pendant le déplacement du substrat (T) dans le sens prédéterminé, et que,
pendant l'utilisation, il forme un film d'épaisseur prédéterminée de la matière d'évaporation sur la couche de mélange à partir de la source d'évaporation (5', 50) par évaporation sous vide, alors que le substrat (T) se déplace de façon continue,
caractérisé en ce que :
l'irradiation par la source d'ions (4', 40) et l'évaporation sous vide d'une quantité prédéterminée de la matière d'évaporation de la source d'évaporation (5', 50) sur le substrat (T), pendant l'utilisation, sont réalisées en même temps, avec déplacement continu du substrat, la source d'ions (4', 40) étant disposée de manière que le rayonnement ionique de la source d'ions (4', 40) soit appliqué, pendant l'utilisation, à une partie (B) placée en amont d'une partie centrale (A) dans le sens de déplacement du substrat, la partie amont (B) ayant une plus faible vitesse d'évaporation que la partie centrale (A) si bien qu'une couche de mélange d'atomes de la matière du substrat et d'atomes de la matière évaporée se forme de façon continue à la surface du substrat (T) dans la partie (B) dans laquelle l'irradiation ionique est appliquée, puis qu'un film d'évaporation sous vide d'épaisseur prédéterminée soit formé de façon continue sur la couche de mélange dans la partie (A) dans laquelle l'irradiation ionique n'est pas appliquée, et
la source d'ions (4', 40) peut fonctionner indépendamment de la source d'évaporation (5', 50 ), si bien que, pendant le fonctionnement, l'irradiation ionique par la source d'ions (4', 40) destinée à former la couche de mélange peut être réalisée de manière que le rapport M/N du nombre M d'atomes de la matière d'évaporation au nombre N d'ions atteignant la surface du substrat (T) par unité de temps et par unité de surface soit compris entre 10 et 1 000.

6. Appareil de formation de film selon la revendication 5, dans lequel la source d'ions est disposée de manière que, pendant l'utilisation, une partie du rayonnement ionique soit appliquée simultanément à la surface du substrat en amont de la région de surface atteinte par la matière d'évaporation de la source d'évaporation, si bien que la surface du substrat subit un traitement préalable avant la formation de la couche de mélange.
